# EUROPÄISCHE PATENTANMELDUNG

(11) **EP 3 628 988 A1**
(43) Veröffentlichungstag der Anmeldung: **01.04.2020**
(21) Anmeldenummer: 19200255.8
(22) Anmeldetag: 27.09.2019
(51) Int. Cl.: G01J 1/44, G06K 9/00

(54) **VERFAHREN ZUR AUSWERTUNG EINES EINZELPHOTONEN-DETEKTORSIGNALS**

(30) Priorität: 28.09.2018 DE 102018124123
(71) Anmelder: Leica Microsystems CMS GmbH, 35578 Wetzlar (DE)
(72) Erfinder: Birk, Holger, 74909 Meckesheim (DE); Widzgowski, Bernd, 69221 Dossenheim (DE)
(74) Vertreter: m patent group

(57) **Zusammenfassung**

Die Erfindung betrifft ein Verfahren zur Auswertung eines Einzelphotonen-Detektorsignals, wobei das Einzelphotonen-Detektorsignal in ein erstes und ein zweites Signal dupliziert wird, wobei das erste Signal bearbeitet wird und das zweite Signal entweder nicht bearbeitet wird oder anders bearbeitet wird als das erste Signal, woraufhin ein Differenzsignal zwischen dem bearbeiteten oder unbearbeiteten zweiten Signal und dem bearbeiteten ersten Signal gebildet wird, wobei das Differenzsignal ausgewertet wird, um Pulsereignisse zu ermitteln.

## Beschreibung

Die vorliegende Erfindung betrifft ein Verfahren zur Auswertung eines Einzelphotonen-Detektorsignals sowie eine Anordnung, eine Recheneinheit und ein Computerprogramm zu dessen Durchführung.

### Stand der Technik

Beispielsweise in der konfokalen Mikroskopie werden möglichst empfindliche Lichtdetektoren eingesetzt, um das von der Probe ausgehende Fluoreszenzlicht mit einem möglichst guten Signal/Rauschverhältnis und quantitativ so genau wie möglich zu erfassen. Hierzu eignen sich unterschiedliche Typen von Photomultipliern. Es ist insbesondere wünschenswert, hierzu auch Halbleiter-Photomultiplier (HlPM) wie Silizium-Photomultiplier (SiPM) einzusetzen, da diese bei vergleichsweise geringen Kosten Vorteile bei Empfindlichkeit, Zeitauflösung und Robustheit bieten.

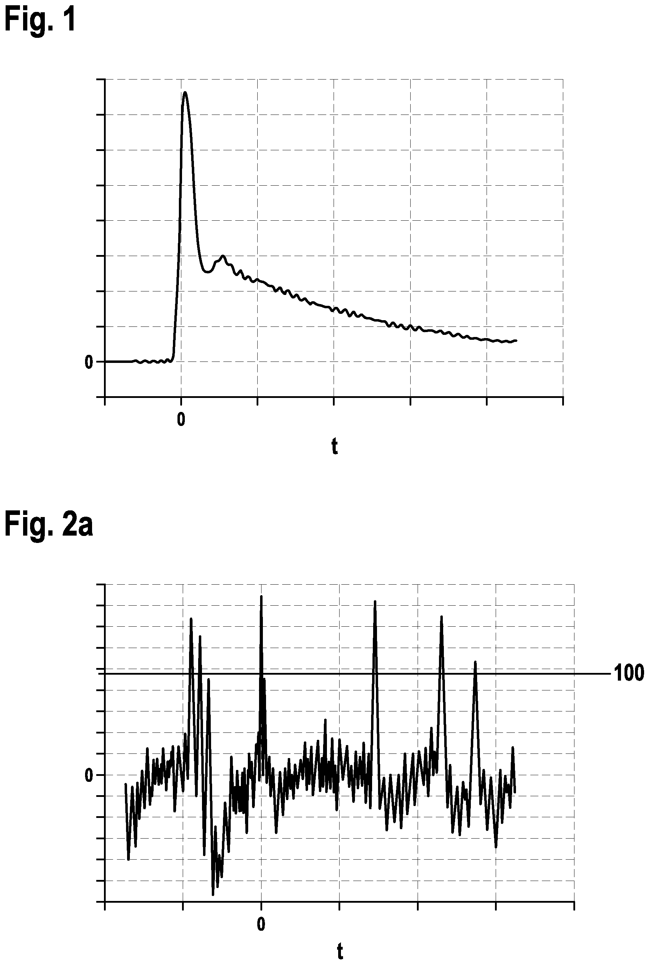

Bei einem HlPM entsteht aus jedem detektierten Photon ein analoger Puls, wobei ein typischer Signalverlauf (Intensität über Zeit) in Figur 1 gezeigt ist. Die Pulsform teilt sich in einen schnellen Anstieg im ns- bis sub-ns-Bereich sowie einen Abfall im Bereich von typischerweise 20-100ns auf. Die Signalhöhe ist im Wesentlichen durch die Vorspannung oberhalb des Lawinendurchbruchs sowie die Kapazität der einzelnen Zelle, sowie natürlich durch Verstärkungsfaktoren der nachfolgenden Elektronik gegeben. Der schnelle Anstieg ist eine Folge des Durchbruchs, bei dem die Kapazität der vorgespannten Diode bis unter die Durchbruchsspannung entladen wird, der langsamere Abfall ergibt sich aus der RC-Zeitkonstanten in Kombination mit dem sog. "Quenching"-Widerstand. Die Fläche unter der Signalkurve entspricht sozusagen der Ladung, welche bei dem Durchbruch freigesetzt wurde. Ein SiPM mit für die konfokale Mikroskopie sinnvollen Dimensionen (z.B. 1,3mm x 1,3mm; 200-1500 einzelne, parallel geschaltete Zellen) liefert mit großer Homogenität gleich große Signale beziehungsweise gleichviel Ladung für jede von einem Photon getroffene Zelle.

Grundsätzlich kann bei Photomultipliern die Datenaufnahme entweder im Zähl- oder im Integrations-Modus (auch Digital- bzw. Analog-Modus genannt) erfolgen.

Ein möglicher Ansatz, ein zur Anzahl der einfallenden Photonen proportionales Signal zu erhalten, besteht darin, die Ereignisse zu zählen, indem das analoge Signal mit einer Schwelle verglichen wird und bei jeder Überschreitung ein Zähler erhöht wird. Sobald sich Pulse überlagern, ist die gemessene Zählrate allerdings kleiner als die tatsächliche Anzahl von Ereignissen. Bei Kenntnis der vorliegenden Photonenstatistik sowie bei bekannter Pulsform des Detektionssignals kann man auf den Fehler Rückschlüsse ziehen und gegebenenfalls korrigieren. Im Fall von gepulster Anregung ist für eine erfolgreiche Korrektur auch die Kenntnis der Fluoreszenzlebensdauer nötig. D.h. die Korrektur hat probenabhängig zu erfolgen, was mit Mehraufwand verbunden ist.

Eine weitere Möglichkeit, die Fehler beim Zählen von Pulsen möglichst klein zu halten, besteht darin, die Pulse in eine möglichst kurze Form zu bringen. Dies kann entweder durch Hochpassfiltern des Ausgangssignals oder durch einen kapazitiven Abgriff zwischen Diode und Quenching-Widerstand, wie z.B. in US 2013/0099100 A1 gezeigt, geschehen. Damit wird jedoch die Signalhöhe reduziert.

Um das Auftreffen eines Photons zu erkennen und die Signale eines Einzelphotonen-Detektors mit hoher Zeitauflösung zu erfassen, insbesondere bei zeitlich dichter Abfolge der detektierten Photonen, kann das hochpassgefilterte Signal verstärkt und anschließend mit einem Schwellwert verglichen werden. Sobald der Schwellwert überschritten ist, wird ein digitales Signal erzeugt, welches mit hoher zeitlicher Auflösung weiter verarbeitet werden kann. Zum Auskoppeln des hochpassgefilterten Signals kann z.B. ein passives RC-Glied, also Widerstand und Kondensator mit nachfolgendem Verstärker verwendet werden.

Dieses hochpassgefilterte Signal weist dabei in der Regel immer Spannungskomponenten oberhalb und unterhalb der Ruhelage auf, so dass die Flächen oberhalb und unterhalb der Ruhelage nahezu gleich groß sind. Dies hat zur Folge, dass bei mehreren dicht aufeinander folgenden Pulsen die Höhe der Pulse davon abhängt, wie sie sich mit vorangegangenen Pulsen überlagern. Dadurch können entweder Pulse verloren gehen oder zum falschen Zeitpunkt beziehungsweise im Fall von Nachschwingen auch zu viel gezählt werden. Figur 2a zeigt einen möglichen Kurvenverlauf eines hochpassgefilterten Signals mit mehreren aufeinanderfolgenden Pulsen auf einer längeren Zeitskala als Figur 1. Der Schwellwert ist mit 100 bezeichnet. Bei beispielsweise drei dicht nacheinander folgenden Pulsen sinkt die Pulshöhe möglicherweise unter den Schwellwert 100 ab, so dass in diesem Beispiel der dritte Puls nicht gezählt wird.

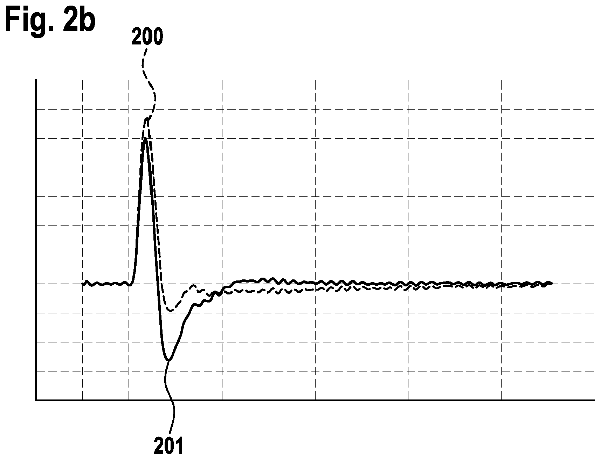

Ein Grund für dieses Phänomen ist unter anderem das nichtideale Verhalten realer Filter. Bei realen Filtern im Frequenzbereich von etlichen MHz spielen beispielsweise auch parasitäre Induktivitäten und Kapazitäten eine Rolle, so dass meist nicht nur ein einfacher Hochpassfilter erster Ordnung entsteht. Wie in Figur 2b veranschaulicht, entspricht ein reales hochpassgefiltertes Signal 201 beispielsweise einem Filter 2. Ordnung. Im Unterschied zu einem idealen Verlauf 200 folgt dem kurzen Puls nach oben ein deutliches Unterschwingen. Überlagert sich ein zweiter Puls so, dass das Maximum des zweiten Pulses auf das Minimum des ersten Pulses trifft, wird die Höhe des zweiten Pulses entsprechend verfälscht.

Erschwerend kommt hinzu, dass die Signale eines hier bevorzugten HlPM meist nur 1-2 mV groß sind und daher in der Praxis verstärkt werden, beispielsweise um einen Faktor 100. Dabei wird aber auch jeder Offset entsprechend verstärkt. Man kann nun zwar das Signal mit mehreren Verstärkerstufen verstärken, wobei jede Stufe jeweils nur das hochpassgefilterte Signal der vorangehenden Stufe verstärkt, um den Offset klein zu halten. Dadurch wird aber das reale Verhalten mit Unterschwingen begünstigt.

Es ist daher wünschenswert, die Nachteile aus dem Stand der Technik zu reduzieren oder zu überwinden und die Signale eines Einzelphotonen-Detektors mit besserer Zeitauflösung und höherer Genauigkeit zu erfassen.

### Offenbarung der Erfindung

Erfindungsgemäß werden ein Verfahren zur Auswertung eines Einzelphotonen-Detektorsignals, eine Anordnung, eine Recheneinheit, ein Computerprogramm zu dessen Durchführung und ein Speichermedium mit den Merkmalen der unabhängigen Patentansprüche vorgeschlagen. Vorteilhafte Ausgestaltungen sind Gegenstand der Unteransprüche sowie der nachfolgenden Beschreibung.

Das erfindungsgemäße Verfahren zur Auswertung eines Einzelphotonen-Detektorsignals zeichnet sich dadurch aus, dass das Einzelphotonen-Detektorsignal - gewünschtenfalls nach einer Vorverarbeitung, insbesondere Verstärkung, jedoch ohne Hochpassfilterung - in ein erstes und ein zweites Signal dupliziert wird, wobei das erste Signal bearbeitet wird und das zweite Signal entweder nicht bearbeitet wird oder anders bearbeitet wird als das erste Signal, woraufhin ein Differenzsignal zwischen dem bearbeiteten oder unbearbeiteten zweiten Signal und dem bearbeiteten ersten Signal gebildet wird, wobei das Differenzsignal ausgewertet wird, um Pulsereignisse zu ermitteln. Beispielsweise können die Pulse gezählt und/oder Zeitpunkte für die Pulse ermittelt werden.

Die Erfindung basiert somit auf der Idee, eine herkömmliche Hochpassfilterung durch die Differenzbildung unterschiedlich bearbeiteter Signale zu ersetzen.

Die Erfindung bietet insbesondere den Vorteil, dass im Gegensatz zur hochpassgefilterten Variante mit realen Filtern keine oder kaum eine Verschiebung der Pulshöhen abhängig von der Abfolge der Pulse stattfindet. Ein weiterer Vorteil ist, dass sich vorhandene Offsets durch die Duplizierung in zwei Pfade und anschließende Differenzbildung erst am Ende der Verstärkerkette gegenseitig aufheben.

Die Auswertung des Differenzsignals kann grundsätzlich bekannte Methoden umfassen, beispielsweise einen Schwellwertvergleich, wobei das Differenzsignal mit einem Schwellwert verglichen wird, wobei für jede Schwellwertüberschreitung ein Pulsereignis ermittelt wird. Anstatt die Einzelphotonenereignisse durch Vergleich mit einem Schwellwert zu zählen, kann das Differenzsignal auch über Zeitintervalle integriert werden, um einen zur Photonenzahl proportionalen Integralwert zu erhalten. Das ist vor allem dann sinnvoll, wenn die einzelnen Ereignisse sehr dicht oder auch gleichzeitig auftreten. Beim Zählen gehen in diesem Fall Ereignisse verloren, während beim Integrieren pro Ereignis fast gleiche Flächen unter der Kurve des Differenzsignals entstehen. Eine Integration liefert also bei hohen Lichtintensitäten eher einen Wert, der proportional zur Lichtintensität ist. Ein Schwellwertvergleich liefert dagegen die bessere Zeitauflösung.

In einer vorteilhaften Ausführungsform umfasst das Bearbeiten des ersten Signals eine Tiefpassfilterung, bevorzugt mit einer Grenzfrequenz zwischen 20 und 100 MHz, besonders bevorzugt zwischen 50 und 80 MHz. Durch eine Differenzbildung zwischen einem tiefpassgefilterten ersten Signal und einem unbearbeiteten oder anders bearbeiteten zweiten Signal entsteht eine hochfrequente Komponente, die aber im Gegensatz zur hochpassgefilterten Variante mit realen Filtern keine Verschiebung der Pulshöhen abhängig von der Abfolge der Pulse aufweist. Wie erwähnt, kann das Einzelphotonen-Detektorsignal vor der Duplizierung zwar verstärkt werden, wird jedoch nicht hochpassgefiltert, so dass Gleichspannungsanteile (Offsets) mit verstärkt werden. Wird dann das durch Differenzbildung entstandene Signal mit einem Schwellwert verglichen, so lassen sich alle Pulsereignisse korrekt ermitteln. Voraussetzung ist lediglich, dass zwischen zwei Pulsen der Schwellwert unterschritten wird.

In einer bevorzugten Weiterbildung dieser Variante umfasst bevorzugt das Bearbeiten des zweiten Signals eine Tiefpassfilterung mit einer anderen Grenzfrequenz als das erste Signal, bevorzugt mit einer Grenzfrequenz von mindestens 500 MHz, weiter bevorzugt 1 GHz bzw. ca. 1 GHz. Weil die Grenzfrequenz der Tiefpassfilterung des einen Signals höher ist als die Grenzfrequenz der Tiefpassfilterung des anderen Signals, wird noch ein Teil der hochfrequenten Komponente des verstärkten Signals übertragen und bleibt nach der Differenzbildung übrig. In diesem Sinne wirken unterschiedliche Tiefpassfilterung und Differenzbildung wie ein Bandpass.

Es ist auch denkbar, dass das erste Signal und/oder das zweite Signal im Rahmen der unterschiedlichen Bearbeitung hochpassgefiltert und/oder bandpassgefiltert werden.

Zweckmäßigerweise umfasst das Bearbeiten des ersten Signals und/oder des zweiten Signals eine Verzögerung, bevorzugt um Laufzeitunterschiede auszugleichen und/oder um eine differentielle Komponente hinzuzufügen. Insbesondere in den Fällen, in denen das zweite Signal nicht bearbeitet wird, kommt es aufgrund der Bearbeitung des ersten Signals zu Laufzeitunterschieden, welche durch eine gezielte Verzögerung des schnelleren Signals vor der Differenzbildung ausgeglichen werden. Auf diese Weise können gleiche Zeitpunkte des bearbeiteten ersten Signals und des bearbeiteten oder unbearbeiteten zweiten Signals miteinander in Beziehung gesetzt werden.

In einer weiteren vorteilhaften Ausführungsform umfasst das Bearbeiten des ersten Signals und/oder des zweiten Signals eine vorzeichenabhängige und/oder steigungsabhängige Bearbeitung. Im Rahmen einer vorzeichenabhängigen Bearbeitung können insbesondere jeder Signalwert und/oder jeder Differenzwert abhängig von dem Vorzeichen bearbeitet werden. Eine mögliche vorzeichenabhängige Bearbeitung besteht darin, dass negative Signalwerte herausgefiltert beziehungsweise auf null gesetzt werden. Für eine steigungsabhängige Bearbeitung kann insbesondere für jeden Signalwert und/oder jeden Differenzwert eine lokale Steigung bestimmt und in Abhängigkeit davon die Bearbeitung gewählt werden. Eine steigungsabhängige Bearbeitung kann darin bestehen, dass nur Signalabschnitte mit einer Mindeststeigung beziehungsweise einer Höchststeigung durchgelassen werden. Auf diese Weise kann insbesondere eine Hochfrequenzkomponente des Einzelphotonensignals herausgefiltert werden.

Es ist auch denkbar, dass das Bearbeiten des ersten Signals und/oder des zweiten Signals eine individuelle Verstärkung oder Abschwächung umfasst. Verschiedene Skalierungen sind dabei denkbar. Insbesondere werden das erste Signals und/oder das zweite Signal so verstärkt bzw. abgeschwächt, dass das Differenzsignal nach einem Pulsereignis möglichst konstant, beispielsweise null ist bzw. dass bei dicht aufeinanderfolgenden Pulsereignissen nach jedem der Pulsereignisse in etwa immer dieselbe Differenzsignalhöhe vorliegt und dieser Wert mit zunehmender Anzahl Pulse nicht nach unten oder oben wegläuft. Dies ist vorteilhaft, da auf diese Weise eine stabile Auswertung möglich ist.

In einer weiteren vorteilhaften Ausführungsform werden ein oder mehrere Signale in der Kette, d.h. Detektorsignal, erstes Signal, zweites Signal (jeweils vor oder nach einer Bearbeitung), Differenzsignal, mit hinreichend großer Abtastrate digitalisiert (d.h. um einen Puls mit einer schnellen Komponente von etwa 1-2 ns noch erfassen zu können) und die weiteren Verfahrensschritte werden rechnerisch durchgeführt. Dies ist bei einer Abtastrate von mindestens 2 GHz der Fall. Dies ist vorteilhaft, da auf diese Weise eine präzise digitale Berechnung möglich wird.

Weitere Vorteile und Ausgestaltungen der Erfindung ergeben sich aus der Beschreibung und der beiliegenden Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in den Zeichnungen schematisch dargestellt und wird im Folgenden unter Bezugnahme auf die Zeichnungen beschrieben.

### Figurenbeschreibung

- Figur 1: zeigt eine Kurvenform eines Einzelphotonen-Detektorsignals;
- Figur 2a: zeigt einen möglichen Kurvenverlauf eines hochpassgefilterten Detektorsignals;
- Figur 2b: zeigt einen Vergleich zwischen einem ideal und einem real hochpassgefilterten Signal;
- Figur 3: zeigt eine funktionsorientierte Darstellung einer Ausführungsform des erfindungsgemäßen Verfahrens;
- Figur 4a: zeigt einen Verlauf eines ersten bearbeiteten und eines zweiten unbearbeiteten Signals gemäß einer Ausführungsform der Erfindung;
- Figur 4b: zeigt einen Verlauf der Differenz der beiden Signale aus Figur 4a;
- Figur 5: zeigt eine Oszilloskop-Aufnahme mit einer direkten Messung des Einzelphotonen-Detektorsignals und mit einer Aufnahme nach einer Bearbeitung gemäß einer Ausführungsform eines erfindungsgemäßen Verfahrens;
- Figur 6: zeigt eine funktionsorientierte Darstellung einer weiteren Ausführungsform des erfindungsgemäßen Verfahrens;
- Figur 7: zeigt eine Übersicht über die typischen Elemente eines konfokalen Mikroskops in schematischer Ansicht.

Figur 1 zeigt eine Kurvenform eines Einzelphotonen-Detektorsignals. Bei jedem detektierten Photon entsteht ein Puls mit einer schnellen Komponente (ca. 1-2 ns) gefolgt von einer etwas langsameren Komponente (ca. 30-60 ns). Die Pulsform teilt sich in einen schnellen Anstieg im ns- bis sub-ns-Bereich sowie einen Abfall im Bereich von typischerweise 30-60 ns auf. Die Signalhöhe ist im Wesentlichen durch die Vorspannung oberhalb des Lawinendurchbruchs sowie die Kapazität der einzelnen Zelle, sowie natürlich durch Verstärkungsfaktoren der nachfolgenden Elektronik gegeben. Der schnelle Anstieg ist eine Folge des Durchbruchs, bei dem die Kapazität der vorgespannten Diode bis unter die Durchbruchsspannung entladen wird, der langsamere Abfall ergibt sich aus der RC-Zeitkonstanten in Kombination mit dem sog. "Quenching"-Widerstand.

Figur 2a zeigt einen möglichen Kurvenverlauf eines hochpassgefilterten Einzelphotonen-Detektorsignals. Um das Auftreffen des Photons zu erkennen, wird das hochpassgefilterte Einzelphotonen-Detektorsignal im Stand der Technik verstärkt und anschließend mit einem Schwellwert verglichen. Sobald der Schwellwert überschritten ist, wird ein digitales Signal erzeugt, welches mit hoher zeitlicher Auflösung weiter verarbeitet werden kann. Zum Auskoppeln der hochfrequenten Komponente wird in der Regel wie oben bereits erwähnt ein Kondensator verwendet. Das hochpassgefilterte Signal weist dabei immer Spannungskomponenten oberhalb und unterhalb der Ruhelage auf, so dass die Flächen oberhalb und unterhalb der Ruhelage nahezu gleich groß sind. Dies hat zur Folge, dass bei mehreren dicht aufeinander folgenden Pulsen die Höhe der Pulse davon abhängt, wie sie sich mit vorangegangenen Pulsen überlagern. Dadurch können entweder Pulse verloren gehen oder zum falschen Zeitpunkt beziehungsweise im Fall von Nachschwingen auch zu viel gezählt werden.

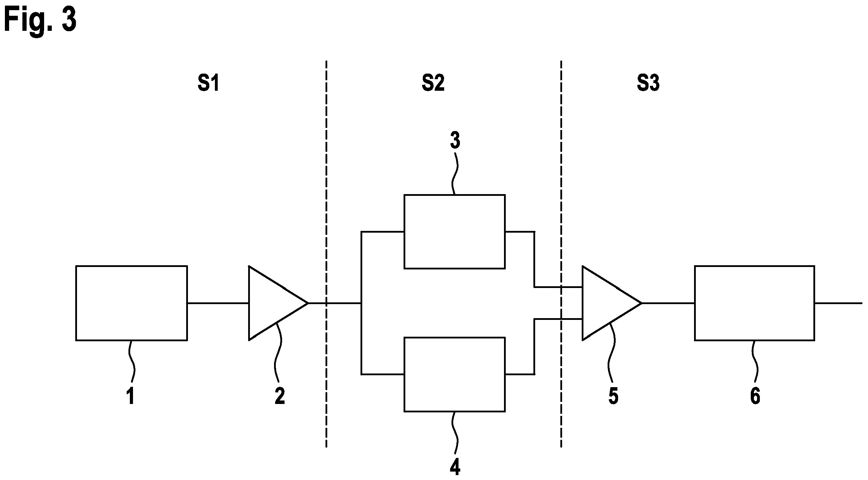

Figur 3 zeigt eine Anordnung zur Durchführung einer Ausführungsform eines erfindungsgemäßen Verfahrens. Dabei wird in einem Detektor 1 ein Einzelphotonen-Detektorsignal erzeugt. Dieses Signal wird im vorliegenden Beispiel zunächst an einen Verstärker 2 weitergeleitet. Dort wird das Signal verstärkt und in zwei Signale dupliziert. Das erste Signal wird an eine erste Bearbeitungseinheit 3und das zweite Signal an eine zweite Bearbeitungseinheit 4 weitergeleitet.

In der ersten Bearbeitungseinheit 3 wird das erste Signal bearbeitet, bevorzugt tiefpassgefiltert. In der zweiten Bearbeitungseinheit 4 wird das zweite Signal entweder unbearbeitet weitergeleitet oder anders bearbeitet als das erste Signal in der ersten Bearbeitungseinheit 3. Bevorzugt wird das zweite Signal in der zweiten Bearbeitungseinheit 4 laufzeitverzögert, um eine Laufzeitdifferenz zwischen dem ersten und zweiten Signal zu kompensieren. Insbesondere weisen die erste Bearbeitungseinheit 3 und/oder die zweite Bearbeitungseinheit 4 jeweils einen Verstärker oder Abschwächer auf, der dazu eingerichtet ist, die jeweiligen Signale individuell zu verstärken oder abzuschwächen. Ein Abschwächer kann dabei insbesondere als einfacher - insbesondere einstellbarer - Widerstand ausgebildet sein.

Das bearbeitete erste Signal und das bearbeitete zweite Signal werden dann an einen Differenzbildner 5 weitergegeben, in dem ein Differenzsignal zwischen dem bearbeiteten ersten Signal und dem unbearbeiteten oder bearbeiteten zweiten Signal gebildet und an eine Verarbeitungseinheit 6 weitergegeben wird.

In der Verarbeitungseinheit 6 kann das Differenzsignal beispielsweise digitalisiert und dann ausgewertet werden. Insbesondere wird das Differenzsignal mit einem Schwellwert verglichen, woraus für jede Schwellwertüberschreitung ein Pulsereignis, beispielsweise ein Zeitpunkt für einen Puls ermittelt wird.

Bei festen Signalverstärkungen steigt die Anzahl der gemessenen Pulse mit sinkendem Schwellwert aufgrund schwankender Pulshöhen. Dabei gibt es einen Plateaubereich, bei dem sich die Anzahl der gemessenen Pulse mit variierendem Schwellwert nur wenig ändert. Bevorzugt wird der Schwellwert auf eine Mitte des Plateaubereichs eingestellt. Durch Variation der Verstärkung/Abschwächung der ersten und/oder zweiten Bearbeitungseinheit 3 bzw. 4 kann auch der Plateaubereich variiert werden bzw. kann eine Abhängigkeit der Position des Plateaubereichs von der Zählrate minimiert werden.

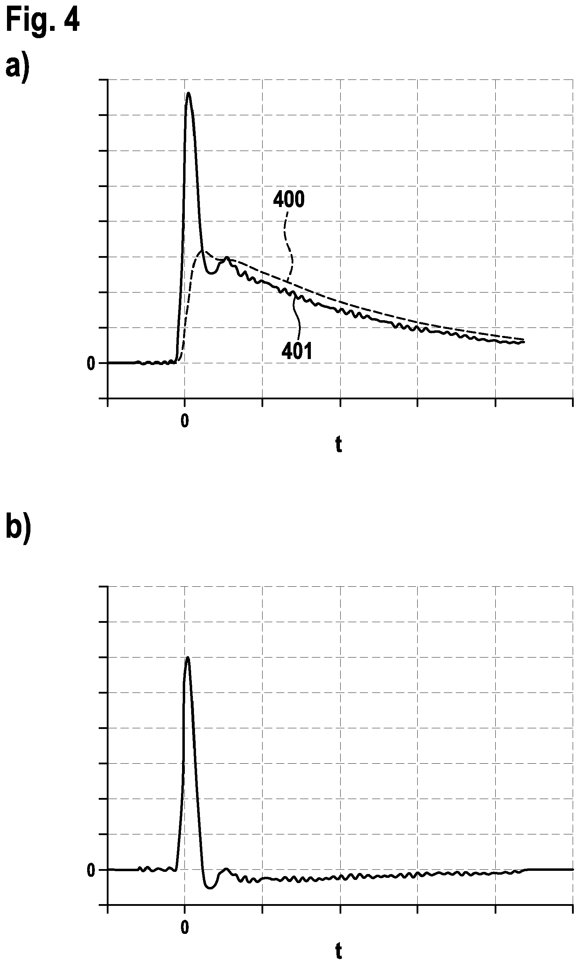

Figur 4a zeigt einen Verlauf 400 eines ersten bearbeiteten Signals und einen Verlauf 401 eines zweiten unbearbeiteten Signals gemäß einer Ausführungsform der Erfindung. Das unbearbeitete Signal entspricht dem verstärkten Einzelphotonen-Detektorsignal. Das bearbeitete Signal wurde als Bearbeitungsschritt mit einer Grenzfrequenz von 50 MHz tiefpassgefiltert. Bei dem tiefpassgefilterten Signal ist zu sehen, dass die Hochfrequenzkomponente des schnellen Pulsanstiegs herausgefiltert worden ist und nicht mehr im tiefpassgefilterten Signal erscheint.

Figur 4b zeigt das Ergebnis der Differenzbildung der beiden Signale aus Figur 4a. Das Ergebnis ist ein starker Puls, der der Hochfrequenzkomponente bei dem schnellen Anstieg des Pulses entspricht. Außerdem sind kleinere Schwingungen zu sehen, die allerdings wenig ins Gewicht fallen. Anhand der Figuren 4a und 4b kann der Einfluss der individuellen Verstärkungen deutlich gemacht werden. Vorzugsweise werden die individuellen Verstärkungen so eingestellt, dass die fallenden Flanken der beiden Signale auslaufende Pulssignale nach dem Peak möglichst übereinander liegen, damit das Differenzsignal dort möglichst null ergibt und nicht nach unten oder oben "wegläuft" und ggf. zu Fehldetektionen führt. In Figur 4a könnten dazu die Verstärkung von 400 etwas reduziert und/oder die Verstärkung von 401 etwas erhöht werden.

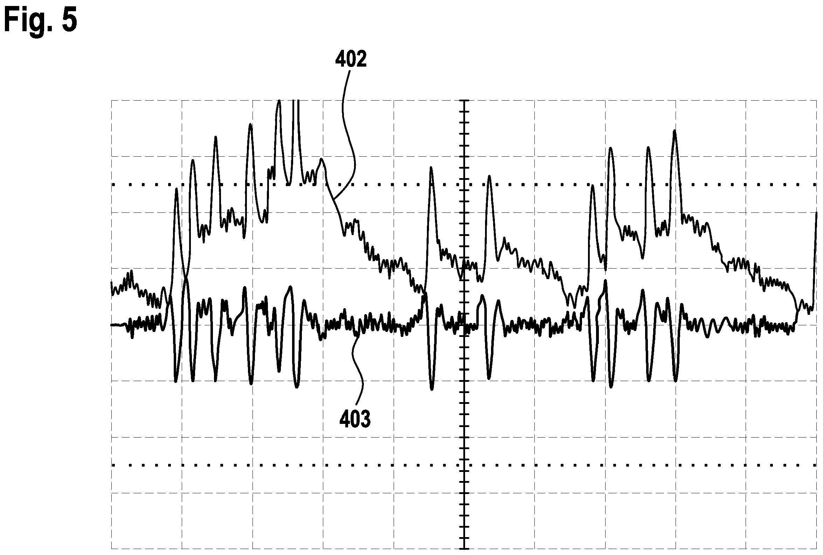

Figur 5 zeigt eine Oszilloskop-Aufnahme, wobei die obere Kurve 402 eine Direktmessung mit einer Lichtmenge, bei der die einzelnen Pulse dicht aufeinanderfolgen, also ein unbearbeitetes Signal zeigt. Um zur unteren Kurve 403 zu gelangen, wurde mittels Berechnung im Oszilloskop zuerst eine Tiefpassfilterung mit einer Grenzfrequenz von 80 MHz durchgeführt und davon dann die obere Kurve abgezogen. Die verbleibenden Pulse sind dann nahezu gleich hoch, unabhängig von der Vorgeschichte.

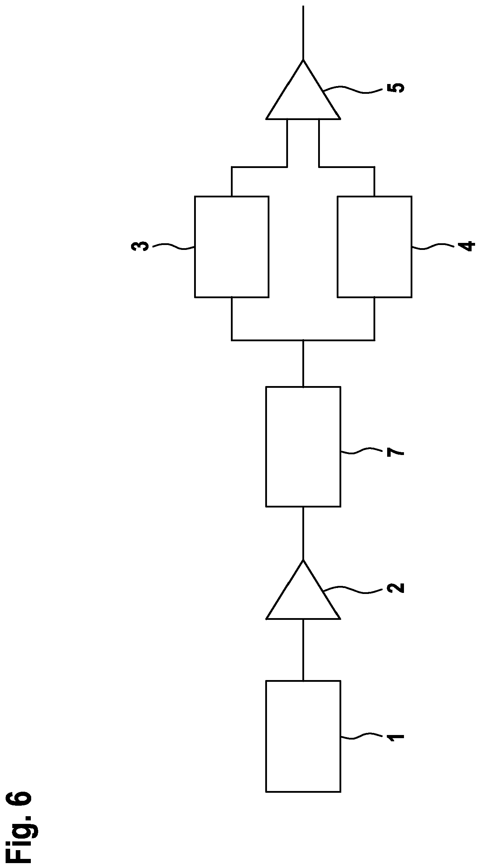

Figur 6 zeigt eine alternative Anordnung zur Durchführung einer Ausführungsform eines erfindungsgemäßen Verfahrens. Dabei wird in einem Detektor 1 ein Einzelphotonen-Detektorsignal erzeugt. Dieses Signal wird an einen Verstärker 2 weitergeleitet. Dort wird das Signal verstärkt und an eine Digitalisierungseinheit 7 weitergegeben. Dort wird das verstärkte Signal mit einer Abtastrate von mindestens 2 GHz digitalisiert. Die weiteren Schritte können nun rechnerisch erfolgen. Es versteht sich daher, dass die im Folgenden beschriebenen Einheiten insbesondere in Form von Software vorliegen können.

Insbesondere wird das digitalisierte Signal in zwei Signale dupliziert, wobei das erste Signal an eine erste Bearbeitungseinheit 3und das zweite Signal an eine zweite Bearbeitungseinheit 4 weitergeleitet werden. In der ersten Bearbeitungseinheit 3 wird das erste Signal bearbeitet, bevorzugt tiefpassgefiltert und in der zweiten Bearbeitungseinheit 4 wird das zweite Signal entweder unbearbeitet weitergeleitet oder anders bearbeitet als das erste Signal in der ersten Bearbeitungseinheit 3. Bevorzugt wird das zweite Signal in der zweiten Bearbeitungseinheit 4 laufzeitverzögert, um eine Laufzeitdifferenz zwischen dem ersten und zweiten Signal zu kompensieren. Insbesondere weisen die erste Bearbeitungseinheit 3 und/oder die zweite Bearbeitungseinheit jeweils einen Verstärker oder Abschwächer auf, der dazu dient, die jeweiligen Signale individuell zu verstärken bzw. abzuschwächen.

Das bearbeitete erste Signal und das bearbeitete oder unbearbeitete zweite Signal werden dann an einen Differenzbildner 5 weitergegeben, in dem ein Differenzsignal zwischen dem bearbeiteten ersten Signal und dem unbearbeiteten oder bearbeiteten zweiten Signal gebildet und an eine Verarbeitungseinheit weitergegeben wird. In der Verarbeitungseinheit wird das Differenzsignal ausgewertet, wobei insbesondere der Verlauf der Differenz mit einem Schwellwert verglichen wird, wobei für jede Schwellwertüberschreitung ein Zeitpunkt für einen Puls ermittelt wird.

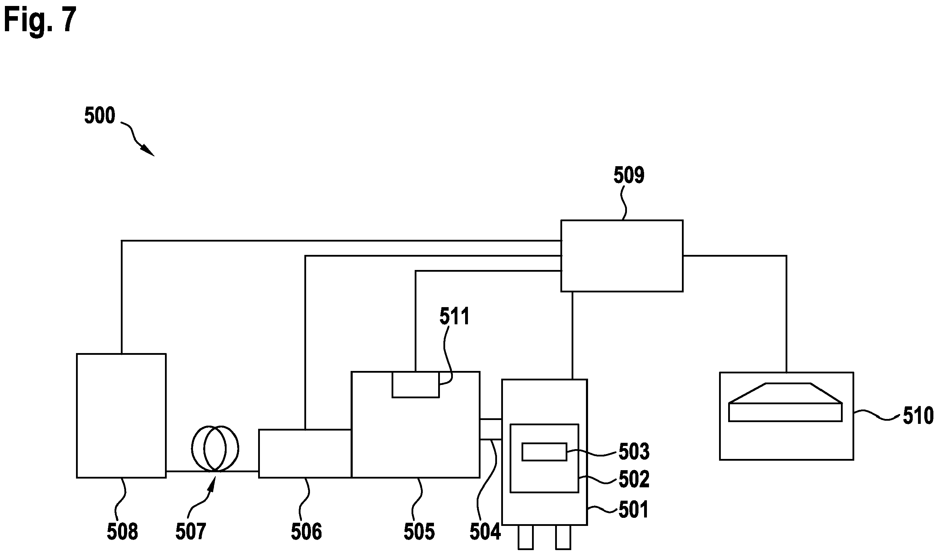

Figur 7 zeigt schematisch ein Konfokalmikroskop mit typischen Komponenten. 500 bezeichnet das Gesamtsystem. Die konfokale Raster- und Detektionseinheit ist mit 505 bezeichnet. Die dazugehörige Beleuchtungseinrichtung ist mit 506 bezeichnet. Bei 508 handelt es sich um eine Laserlichtquelle, die über eine Beleuchtungsfaser 507 mit der Beleuchtungseinrichtung 506 verbunden ist. 504 bezeichnet einen optischen Adapter für die konfokale Raster- und Detektionseinheit 505 am Mikroskopstativ 501. Teil des Stativs 501 ist ein Objekttisch 502 mit einer zu untersuchenden Probe 503. Eine als Steuereinheit 509 ausgebildete Recheneinheit einer erfindungsgemäßen Anordnung steht über entsprechende Verbindungsleitungen mit den einzelnen Komponenten 508, 506, 505 und 501 in Verbindung. Ein Rechner mit Steuer- und Darstellungsprogrammen ist mit 510 bezeichnet; auch er steht mit der Steuereinheit 509 in Verbindung.

Die zu untersuchende Probe 503 wird über eine Mikroskopoptik beleuchtet sowie über dieselbe Mikroskopoptik insbesondere auf eine Sensoranordnung 511 einer erfindungsgemäßen Anordnung abgebildet, die je nach Ausführungsform der konfokalen Raster- und Detektionseinheit 505 aus einem Photomultiplier oder einem Array von Photomultipliern besteht.

Innerhalb der konfokalen Raster- und Detektionseinheit 505 ist in einer ersten Variante ein klassischer konfokaler Strahlengang angeordnet, der in bekannter Weise mit einem einzelnen Pinhole und einem Strahlscanner, beispielsweise einem Spiegelscanner, aufgebaut ist.

In einer zweiten Variante befindet sich innerhalb der konfokalen Raster- und Detektionseinheit 505 ein Strahlengang, bei dem die Probe gleichzeitig mit einem oder mehreren oder in einer Richtung ausgedehnten Beleuchtungspunkten beleuchtet wird. Entsprechend werden die zu detektierenden Photonen beispielsweise mit einer geometrischen Anordnung von Lochblenden (Pinholes) selektiert. Die Sensoranordnung 511 besteht dann aus einem Array von Photomultipliern.

In der zweiten Variante des Gesamtsystems, die ein Mikroskop mit einem Sensorarray, umfasst, sind die einzelnen Photomultiplier, insbesondere SiPM entweder linear oder als zweidimensionale Photomultiplier-Matrix, angeordnet, die gemäß einer bevorzugten Ausführungsform der Erfindung ausgewertet werden.

Die erste Variante des Gesamtsystems weist einen klassischen konfokalen Strahlengang (wie vorab beschrieben) innerhalb der konfokalen Raster- und Detektionseinheit 505 auf. In diesem Fall wird der abgebildete Strahl auf einen einzelnen Photomultiplier, insbesondere einen SiPM, abgebildet, der gemäß einer bevorzugten Ausführungsform der Erfindung ausgewertet wird.

Die Funktionsweise eines in Figur 7 dargestellten Systems 500 ist an sich hinlänglich bekannt und soll daher vorliegend nicht erläutert werden.

### Bezugszeichenliste

- 1: Detektor
- 2: Verstärker
- 3: erste Bearbeitungseinheit
- 4: zweite Bearbeitungseinheit
- 5: Differenzbildner
- 6: Verarbeitungseinheit
- 7: Digitalisierungseinheit

- 100: Schwellwert
- 200: idealer Verlauf
- 201: reales hochpassgefiltertes Signal
- 400: bearbeitetes Signal
- 401: unbearbeitetes Signal
- 402: unbearbeitetes Signal
- 403: bearbeitetes Signal
- 500: Konfokalmikroskop
- 501: Stativ
- 502: Objekttisch
- 503: Probe
- 504: optischer Adapter
- 505: Raster- und Detektionseinheit
- 506: Beleuchtungseinrichtung
- 507: Beleuchtungsfaser
- 508: Laserlichtquelle
- 509: Steuereinheit
- 510: Rechner
- 511: Sensoranordnung

## Patentansprüche

1. Verfahren zur Auswertung eines Einzelphotonen-Detektorsignals, wobei das Einzelphotonen-Detektorsignal in ein erstes und ein zweites Signal dupliziert wird, wobei das erste Signal bearbeitet wird und das zweite Signal entweder nicht bearbeitet wird oder anders bearbeitet wird als das erste Signal, woraufhin ein Differenzsignal zwischen dem bearbeiteten oder unbearbeiteten zweiten Signal und dem bearbeiteten ersten Signal gebildet wird, wobei das Differenzsignal ausgewertet wird, um Pulsereignisse zu ermitteln.

2. Verfahren nach Anspruch 1, wobei das Bearbeiten des ersten Signals ein Tiefpassfiltern umfasst, bevorzugt mit einer Grenzfrequenz zwischen 20 MHz und 100 MHz, besonders bevorzugt zwischen 50 MHz und 80 MHz.

3. Verfahren nach Anspruch 2, wobei das Bearbeiten des zweiten Signals ein Tiefpassfiltern mit einer anderen Grenzfrequenz als das erste Signal umfasst.

4. Verfahren nach einem der vorstehenden Ansprüche, wobei das Bearbeiten des ersten Signals und/oder des zweiten Signals ein Verzögern umfasst, bevorzugt um Laufzeitunterschiede auszugleichen und/oder um eine differentielle Komponente hinzuzufügen, und/oder wobei das Bearbeiten des ersten Signals und/oder des zweiten Signals ein vorzeichenabhängiges und/oder steigungsabhängiges Bearbeiten umfasst.

5. Verfahren nach einem der vorstehenden Ansprüche, wobei das Bearbeiten des ersten Signals und/oder des zweiten Signals ein individuelles Verstärken oder Abschwächen umfasst.

6. Verfahren nach Anspruch 5, wobei das erste Signal und/oder das zweite Signal so verstärkt oder abgeschwächt werden, dass das Differenzsignal nach einem Pulsereignis möglichst konstant ist und/oder dass bei dicht aufeinanderfolgenden Pulsereignissen nach jedem der Pulsereignisse in etwa immer dieselbe Differenzsignalhöhe vorliegt.

7. Verfahren nach einem der vorstehenden Ansprüche, wobei das Einzelphotonen-Detektorsignal vor der Bildung des ersten und zweiten Signals verstärkt wird und/oder nicht hochpassgefiltert wird.

8. Verfahren nach einem der vorstehenden Ansprüche, wobei das Auswerten umfasst, das Differenzsignal mit einem Schwellwert zu vergleichen, wobei für jede Schwellwertüberschreitung ein Pulsereignis ermittelt wird.

9. Verfahren nach einem der vorstehenden Ansprüche, wobei das Auswerten umfasst, das Differenzsignal zu integrieren, wobei aus dem Integralwert eine Anzahl von Pulsereignissen ermittelt wird.

10. Verfahren nach einem der vorstehenden Ansprüche, wobei das Einzelphotonen-Detektorsignal, das erste und zweite Signal oder das Differenzsignal mit einer Abtastrate von mindestens 2 GHz digitalisiert werden und die weiteren Verfahrensschritte rechnerisch durchgeführt werden.

11. Recheneinheit (509, 510), die dazu eingerichtet ist, ein Verfahren nach Anspruch 10 durchzuführen.

12. Anordnung zur Auswertung eines Einzelphotonen-Detektorsignals, die einen Detektor (1), einen Verstärker (2), eine erste Bearbeitungseinheit (3), eine zweite Bearbeitungseinheit (4), einen Differenzbildner (5) und eine Verarbeitungseinheit (6) aufweist, wobei die Anordnung dazu eingerichtet ist, ein Verfahren nach einem der Ansprüche 1 bis 10 durchzuführen.

13. Computerprogramm, das eine Recheneinheit (509, 510) veranlasst, die weiteren Verfahrensschritte des Verfahrens nach Anspruch 10 durchzuführen, wenn es auf der Recheneinheit ausgeführt wird.

14. Maschinenlesbares Speichermedium mit einem darauf gespeicherten Computerprogramm nach Anspruch 13.

15. Mikroskopsystem, Konfokalmikroskopsystem (500) oder Raster-Konfokalmikroskopsystem mit wenigstens einem Photomultiplier (511) und einer Recheneinheit (509, 510) nach Anspruch 11 und/oder einer Anordnung nach Anspruch 12.
